(19) Europäisches Patentamt

European Patent Office

Office européen des brevets

(11) **EP 0 609 928 B1**

(12) **EUROPEAN PATENT SPECIFICATION**

(45) Date of publication and mention
of the grant of the patent:
**23.08.2000 Bulletin 2000/34**

(51) Int. Cl.⁷: $G06F\ 17/50$, $G06F\ 17/60$, $G05D\ 1/00$

(21) Application number: **94200088.6**

(22) Date of filing: **14.01.1994**

(54) **Method and apparatus for identifying or controlling travel to a rendezvous**

Verfahren und Gerät zur Identifikation und Steuerung eines Laufes nach einem Rendezvous

Méthode et appareil pour identifier et contrôler un déplacement vers un rendez-vous

(84) Designated Contracting States:
**DE FR GB**

(30) Priority: **22.01.1993 US 7688**

(43) Date of publication of application:
**10.08.1994 Bulletin 1994/32**

(73) Proprietor:
**Koninklijke Philips Electronics N.V.**
**5621 BA Eindhoven (NL)**

(72) Inventor:
**Trovato, Karen,**
**c/o Int. Octrooibureau B.V.**
**NL-5656 AA Eindhoven (NL)**

(74) Representative:
**Groenendaal, Antonius Wilhelmus Maria et al**
**INTERNATIONAAL OCTROOIBUREAU B.V.,**
**Prof. Holstlaan 6**
**5656 AA Eindhoven (NL)**

(56) References cited:
**EP-A- 0 317 020**

- **PROCEEDINGS 1990 IEEE INTERNATIONAL CONFERENCE ON ROBOTICS AND AUTOMATION, 13 May 1990, US, pages 500-505, XP000139899 WARREN : "multiple robot path coordination using artificial potential fields"**
- **PROCEEDINGS 1989 THE IEEE INTERNATIONAL CONFERENCE ON ROBOTICS AND AUTOMATION, vol. 1, 14 May 1989, SCOTTSDALE AZ US, pages 322-326, XP000042735 BUCKLEY: "fast motion planning for multiple moving robots"**

---

**Description**

BACKGROUND OF THE INVENTION

1. Field of the Invention

The invention relates to a method of selecting paths to at least one rendezvous state, the paths leading from respective sources to the at least one rendezvous state.

The invention in particular relates to a method for planning maneuvers of one or more actors (machines or people), where movement is possible in at least two dimensions, and is subject to two independent space-variant constraints or scenarios. In particular, the invention is applicable to planning travel, for example through time or space, where a rendezvous is required between one actor and another actor or a condition which is also moving through the time or space.

The invention further relates to an apparatus for selecting paths to at least one rendezvous state, the paths leading from respective sources to the at least one rendezvous state.

The most common application for path planning has been for controlling robots. In the typical robot path plan, a path is chosen to get the robot (or a portion of it, such as a gripping member) from a start point to a goal point while avoiding obstacles. Computer simulation/control has improved performance, particularly in multidimensional situations.

Other applications of the invention may lie in traffic or emergency vehicle control, or planning or predicting possible routes or activities of people or machines in dynamic situations.

Prior art discloses among other things, propagating cost waves through a configuration space by budding, using a space-variant metric. In simple path-planning problems, the configuration space represents a two-dimensional discretized physical condition. Using a typical rectangular coordinate system, each configuration state then represents a task state or physical condition which is described by various parameters having known values. A list of these values in a specific order, known as a tuple, describes each configuration state. The configuration space, then, is the span of the tuples.

Goal locations or states are defined, and are fixed for a set of analyses. Selection of a starting position is one step of the planning method.

The cost of transition from one configuration state to another, known as a cost metric but also referred to herein simply as a metric, is defined for each configuration state in a configuration space, with respect to each of its neighbors. Where it is impossible or highly undesirable for an actor (e.g., a machine) to be in a particular configuration state, that state is considered an obstacle. Movement into that state may then be associated with a very high, or infinite, transition cost. The neighborhood may then be defined as including only those states whose transition cost is undefined, or has a finite value -- that is, a permissible state change.

Budding starts at a source, usually the goal or goals in a given configuration space, and is used to generate a direction arrow and a cost-to-goal metric for each state, in a wave of calculations expanding from the goal. A graphical view of this expansion process gives rise to the term "cost wave propagation." The direction arrows generated for each configuration space point back to the lowest cost path to the goal. In controlling robots, this has the advantage that, in the event that the robot has deviated from the optimum path, identification of the state it is in immediately makes the new best path direction known.

A specific improvement to the budding process, described in U.S. patent 4,949,277, involves differential budding of only a small part of the configuration space when, for example, an obstacle or goal is added to, moved a small distance in, or removed from that space.

U.S. patent 5,083,256, discloses a variation of differential budding which takes into account changes in transitions in a configuration space, rather than just changes in the states themselves.

SUMMARY OF THE INVENTION

An object of the invention is to identify a plurality of rendezvous regions within a larger space, in which a planned rendezvous satisfies global constraints.

Another object of the invention is to utilize cost wave propagation from different sources in a more efficient way.

Yet another object of the invention is to optimize paths for at least two actors between separate starting locations and a rendezvous, and for at least one of these actors from the rendezvous to a final goal.

A further object of the invention is to control an actor machine to follow an optimized path from a start to a rendezvous to a final goal.

A still further object of the invention is to provide an apparatus which displays rendezvous regions for at least two actors, which satisfy all global constraints.

Still another object of the invention is to provide an apparatus for controlling an actor machine to follow an optimized path from a start to a rendezvous to a final goal with efficient updating when the environment changes.

The method according to the invention comprises the steps of:

defining a first scenario for travel to achieve a rendezvous condition, the first scenario specifying the location of a first one of the sources and a cost metric,

defining a second scenario for travel to achieve said rendezvous condition, the second scenario specifying the location of a second one of the sources and a cost metric,

forming respective configuration spaces based on said scenarios, said respective spaces having at least one task state in common,

propagating cost waves from the respective source for each configuration space, to determine costs for each configuration state indicating the cost of travel through a said task state in common,

determining a Boolean expression defining a global criterion, encompassing the ways the rendezvous condition can be achieved,

for each said task state in common, evaluating costs of corresponding configuration states according to said Boolean expression to identify candidate rendezvous states, and

providing identification of said candidate rendezvous states to a selecting means for selecting the rendezvous state on the basis of a selection criterion.

The apparatus according to the invention comprises:

means for defining a first scenario for travel to achieve a rendezvous condition, the first scenario specifying the location of a first one of the sources and a cost metric, and a second scenario for travel to achieve said rendezvous condition, the second scenario specifying the location of a second one of the sources and a cost metric,

means for forming respective configuration spaces based on said scenarios, said respective spaces having at least one task state in common,

means for propagating cost waves from the respective source for each configuration space, to determine costs for each configuration state indicating the cost of travel through a said task state in common,

means for determining a Boolean expression defining a global criterion, encompassing the ways the rendezvous condition can be achieved,

means for evaluating, for each said task state in common, said Boolean expression to identify candidate rendezvous states, and

output means for providing identification of said candidate rendezvous states to a selecting means for selecting the rendezvous state on the basis of a selection criterion.

In a first preferred apparatus embodying the invention, responsive to the Boolean results, an apparatus provides control signals for an actor to optimize travel from that actor's start to a rendezvous location.

In another preferred embodiment, an apparatus provides a visual display, pictorial or as a list of setpoints, of the candidate rendezvous regions.

Various advantageous aspects are recited in dependent Claims.

BRIEF DESCRIPTION OF THE DRAWING

The and other aspects and advantages of the invention will become apparent with reference to the description of preferred embodiments, and in particular the appended Figures as follows:

Fig. 1 is a flow diagram showing the basic steps of the method according to the invention,
Fig. 2 is a diagram showing paths generated in a configuration space for a first actor using the scenario of Table 1,
Fig. 3 is a diagram showing paths generated in a configuration space for the first actor using the scenario of Table 2,
Fig. 4 is a diagram showing paths generated in a configuration space for a second actor using the scenario of Table 3,
Fig. 5 is a diagram showing paths generated in a configuration space for the second actor using the scenario of Table 4,
Fig. 6 is a diagram showing the rendezvous states found by evaluating the global constraints in the configuration spaces of Figs. 2-5, and
Fig. 7 is a block diagram of an apparatus for practicing the invention.

## DESCRIPTION OF THE PREFERRED EMBODIMENT

It is common that multiple machines should be coordinated to achieve a larger goal. Typically this involves meeting at a mutually acceptable location (or state). The acceptable region for a specific machine is described in terms of a global constraint. The mutually acceptable locations are referred to as rendezvous locations. Often, only one of these is selected for actual implementation.

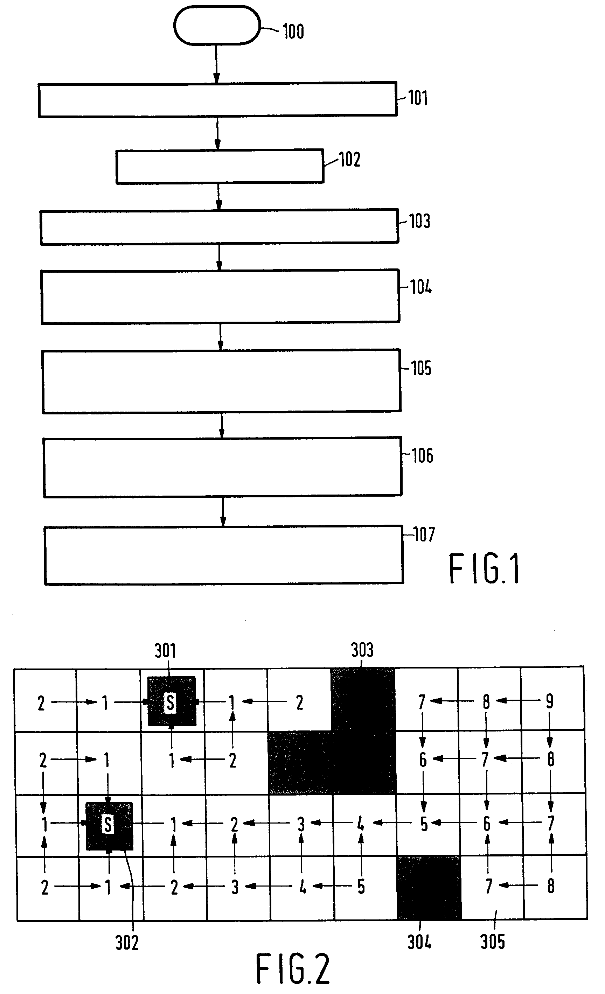

Figure 1 describes the most general method for finding a rendezvous region. Oval 100 indicates the start of the method.

In box 101, actor scenarios are specified. For each scenario specified, a configuration space is created. Typically, the configuration space represents a common region of activity for all the actors. For example, 4 different kinds of trucks (each with their own kinematics and costs) may be driving along the same expanse of desert. Each scenario includes: a name of the scenario which typically also indicates which actor is involved; a source direction for planning, i.e. start or goal; a set of states specifically identifying the source locations; and a metric used to govern the search. While in carrying out a maneuver, there is only one start, there may be more than one alternative start if a plan is to be evaluated.

In box 102, the obstacles are transformed into the configuration space.

In box 103, cost waves are propagated for each scenario according to the specification given in box 101. The source direction is different from the past references to 'start' and 'goal' in that a single path was immediately found between a goal and any starting state. In this situation, waves are propagated outward from the goal as before if the source direction is 'goal'. If the source direction is 'start' though, the waves propagate from the start state, the costs are measured as 'cost_from_start'. This means cost_from_start for the starting state is zero, and calls to the metric function are reversed, e.g.: instead of dist(a,b) dist(b,a) is called, and the arrows point toward rather than away from the start. The mechanism for cost wave propagation is the same except for these differences.

In box 104, the global criterion is evaluated at each configuration state.

In box 105, the rendezvous states that satisfy the global criterion are output. The global criterion is a boolean expression that encompasses all the ways that a satisfactory solution could be achieved.

For example, if at least one of two fuel trucks and an airplane must rendezvous so that the plane (fuel cost metric measured in scenario A) still has at least 100 gallons of fuel in its tank, and the first fuel truck (distance cost metric measured in scenario F1) must travel less than 50 miles, but the second fuel truck (time cost metric measured in scenario F2) can only meet between 2pm and 4pm, then the locations that satisfy all of these constraints comprise the global criterion. Specifically, the global criterion above might look like:

$$G = (A > 100) \text{ and } ((F1 < 50) \text{ or } ((F2 > 1400) \text{ and } (F2 < 1600)))$$

The results of the global criterion are often a printed collection of setpoints, but alternatively they may be a highlighted region on a map. One could think of many useful ways to illustrate the solution.

In box 106, a specific rendezvous state is selected based on a selection criterion. Often this criterion is one which optimizes some collective cost or selects the minimum cost for the most critical of the scenarios. For example, if there are 20 possible rendezvous locations, the rendezvous location that minimizes the fuel consumption for a given actor may be most preferable. Alternatively, a random selection may take place if all rendezvous states are considered equivalent. Still another way to make a selection may be by human directive.

In box 107, selected information may be read out from the set of configuration spaces that represent the scenarios.

If a specific rendezvous state is selected, then paths leading from starting and goal states that lead to that rendezvous state can be read out from the configuration spaces. The path for a specific actor is found by first selecting the configuration space associated with the scenario that contained the start for that actor and tracing the path from the rendezvous state back to the start. Since the transitions would be listed in reverse order compared to how they would typically be carried out, the path should be reversed. From the specific rendezvous point, the remainder of the path for a specific actor is found by selecting the configuration space associated with the scenario that contained the goal for that actor and tracing the path from the rendezvous state back to the goal. Since the transitions would be listed in the order in which they would typically be carried out, the path need not be reversed.

If the costs associated with the path are required, they can be read out at a specific rendezvous state. For example, the cost from the start to the rendezvous state can be read out in the configuration space associated with the scenario that contains the goal for that actor. The cost from the rendezvous state to the goal an be read out in the configuration space associated with the scenario that contains the goal for that actor.

A simple example illustrating the steps given in Figure 1 is described with reference to Figures 2-6. Tables 1-4 are specifications of scenarios as are needed in box 101 of Figure 1. The obstacle layout necessary for the step in box 102 of Figure 1 for the following simple example is presumed to be the same for each of the scenarios. In other

**EP 0 609 928 B1**

scenarios, the obstacle layout for each scenario may be different, even if the terrain is the same. For example, a river may be an obstacle for a car that must drive along the banks and over bridges, however for a boat, the same terrain produces obstacles along the banks and at low bridges.

Table 1 is a simplified specification of machine A, scenario 1. In this scenario, two start states are given, and the minimum distance criterion is selected as a metric. Naturally, other metrics may be selected including user-provided look-up tables and complex formulas.

Table 1

Scenario a1 /* actor a: scenario 1 */

Start /* tells whether to propagate away or towards the 'source' */

    3,2  /* equivalent locations that the actor could start from */

    1,3  /* coordinates are listed < row > , < column >

Metric

    Min_distance /* horiz & vert. moves only, each move is cost=1 */

Figure 2 shows a simplified example of the paths generated using cost wave propagation in a configuration space with the scenario of Table 1. This corresponds to the method of box 103 in Figure 1. The obstacles are three states in 303 and one in 304. The cost_from_start is given at each state. Direction arrows point into the equivalent starting states 301 and 302.

Table 2 is a simplified specification of machine A, scenario2. In this scenario, two goal states are given, and the minimum distance criterion is selected as a metric.

5

Table 2

Scenario a2/* actor a: scenario 2 */

Goal /* tells whether to propagate away or towards the 'source' */

    4,8   /* equivalent goal locations that the actor could arrive at*/

    1,7

Metric

    Min_distance /* horiz & vert. moves only, each move is cost=1 */

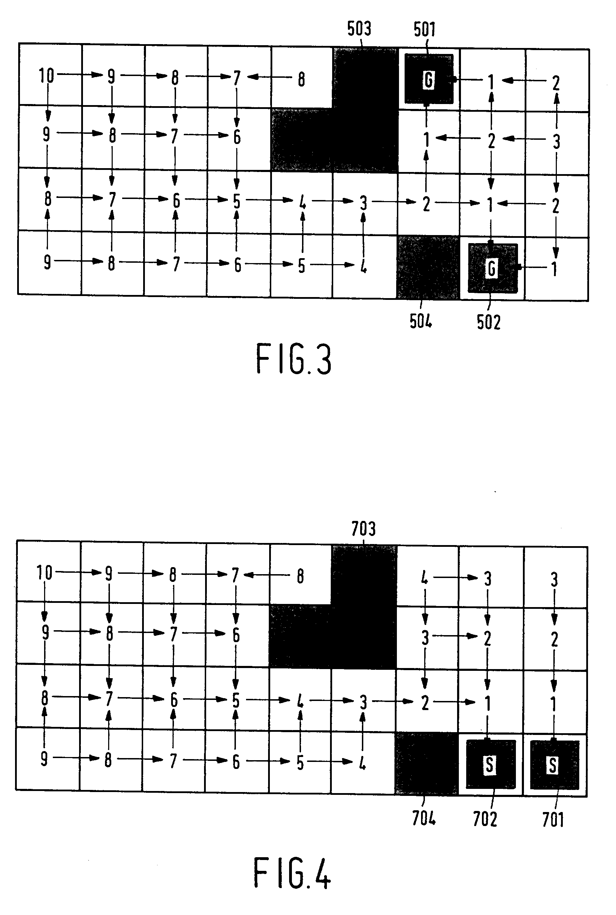

Figure 3 shows a simplified example of the paths generated using cost wave propagation in a configuration space with the scenario of Table 2. This corresponds to the method of box 103 in Figure 1. The obstacles are three states in 503 and one in 504. Direction arrows point into the equivalent goal states 501 and 502.

Table 3 is a simplified specification of machine B, scenario 1. In this scenario, two start states are given, and the minimum time criterion is selected as a metric.

Table 3

Scenario b1/* actor b: scenario 1 */


Start /* propagate away from the 'source' */


    4,8   /* equivalent locations that the actor could start from */


    4,9   /* coordinates are listed <row>, <column>


Metric


    Min_time /* horiz & vert. moves only, each move is cost=1 */


Figure 4 shows a simplified example of the paths generated using cost wave propagation in a configuration space with the scenario of Table 3. This corresponds to the method of box 103 in Figure 1. The obstacles are three states in 703 and one in 704. Direction arrows point into the equivalent starting states 701 and 702.

Table 4 is a simplified specification of machine B, scenario 2. In this scenario, two goal states are given, and the minimum fuel criterion is selected as a metric.


Table 4


Scenario b2/* actor b: scenario 2 */


Arrive /* propagate towards the 'source' */


    3,2   /* equivalent locations that the actor could start from */


    1,3   /* coordinates are listed <row>, <column>


Metric


    Min_fuel /* horiz & vert. moves only, each move is cost=1 */


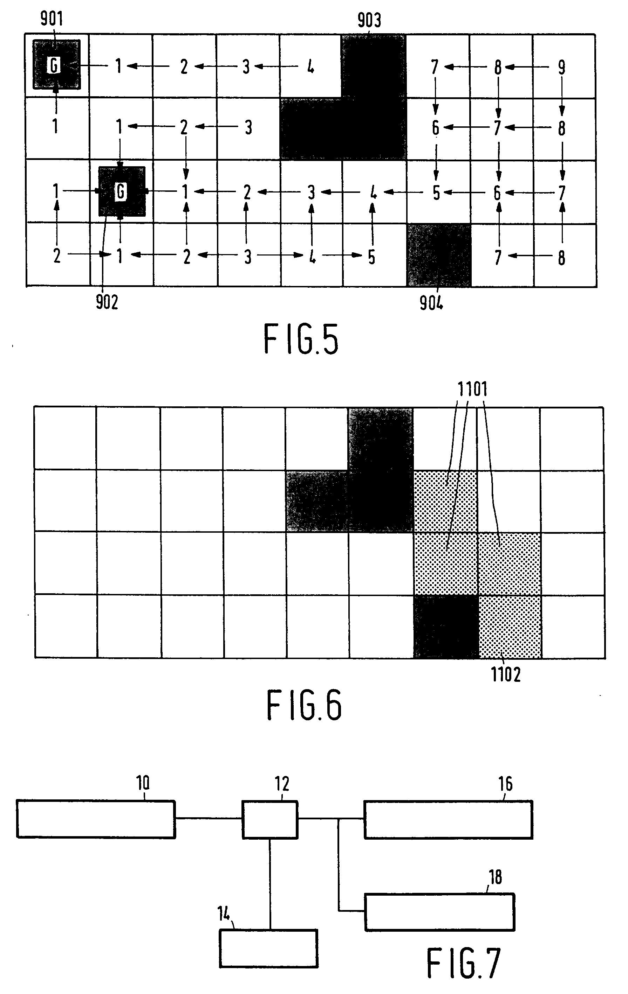

Figure 5 shows a simplified example of the paths generated using cost wave propagation in a configuration space with the scenario of Table 4. This corresponds to the method of box 103 in Figure 1. The obstacles are three states in 903 and one in 904. Direction arrows point into the equivalent goal states 901 and 902.

The global constraint for this simple example is defined by the following Boolean expression:

$$(a1 > 2) \& (a1 < = 8) \& ((a1+a2) = 7) \& (b1 < 4) \& (b2 > 4) \& (a2+b2 <9) \& ((a2 + b2) > 6)$$

This is used to perform the method given in box 104 of Figure 1. In this simple example, the global constraint is in effect saying that the rendezvous solution must satisfy the following criteria (restrictions):

1) the distance A travels from the start to the rendezvous state must be between (2,8).
AND
2) the distance A travels in total must be precisely 7.
AND
3) the time b travels from the start to the rendezvous state must be less than 4
AND
4) The fuel spent by b from the rendezvous state to the goal must be at least 4,
AND
5) the sum of the (distance travelled by a + the fuel spent by b) must be less than 9
AND
6) the sum of the (distance travelled by a + the fuel spent by b) must be greater than 6.

Any boolean combination is acceptable, including, but not limited to standard expressions which use the OR, and XOR operators, and any mathematical expressions as operands for comparison (i.e. >, =, or <)testing.

At each state, the global constraint is evaluated. It is more efficient, but not required, that the least computationally expensive and most likely to fall sub-expression be placed early in the constraint. This is because current compilers perform 'short circuit evaluation' where if it is possible to determine the final result of the expression before all the sub-expressions are evaluated, then the remainder are not tested.

If the global constraint results in TRUE, then the state is a rendezvous state.

In Figure 6, the states that satisfy the global constraint 1101 and 1102 are highlighted with a crosshatch. Alternatively, the coordinates can be output. This corresponds to the method specified in Box 105 of Figure 1.

For any selected individual rendezvous state, the paths for each of the actors to follow from their respective starts to their respective goals can be retrieved by tracing from the rendezvous state in the respective configuration spaces.

For example, if the selected rendezvous state is 1102 of Figure 6 having coordinate (4,8), then Actor A would follow from the starting state 302 in Figure 2 at coordinate (3,2) to (3,3), (3,4), (3,5), (3,6), (3,7), (3,8), and finally to (4,8). Reiterating, this is achieved by tracing from rendezvous state 305 at coordinate (4,8) in Figure 2, back to the nearest start, and then reversing the path. In addition to knowing the path, the cost to move from the start to the rendezvous state is 7. To find the path that Actor A should take to the goal from the rendezvous state 1102 of Figure 6 is obtained by tracing from the coordinate (4,8) in Figure 5 to the nearest goal. In this case, the actor is already at the goal 502, so no movement is necessary. The cost to get to the goal is zero.

Likewise, the paths and costs for Actor B can be found.

All of the paths and costs for all of the actors for each rendezvous state can be routinely displayed, or only selected ones.

Permissible Variations:

a) Mapping Common Task Spaces Between Machines (Actors)

In box 101 of Figure 1, the configuration spaces for the various actors may be of different shapes and sizes, but there must be a mapping so that common regions can be identified. For example, one actor may be planning motions within New York, New Jersey, and Connecticut, while a second actor may plan motions within New York, New Jersey, Delaware, and Maryland. It is readily apparent that any rendezvous would occur in New York or New Jersey. To handle this type of problem, a method for mapping common areas must be provided. Non-common areas will still be required for the planning (i.e. methods 101, 102, and 103 of Figure 1), although only common areas should be evaluated (the method in box 104 of Figure 1) to find the states that might satisfy the global criterion.

Another common type of problem is one where multiple machines work in the same physical region (referred to as 'task space'), although their respective configuration spaces may look quite different (i.e. one machine may have 2 degrees of freedom, but another may have 3 degrees of freedom). The global criterion may specify docking distances between the machines for example. In addition, it is often possible to narrow down the region where a rendezvous could possibly take place, although it is not required. The expected rendezvous region would likely be a subset of the full task space. This expected rendezvous region must be transformed into the respective configuration spaces of each of the machines. This capability already exists since it is the same method needed to perform obstacle transformations. For each transformed state in the task space, the global criterion is evaluated.

b) Improved Efficiency When Fixed Combinations of Actors are Identified

When there are only two actors that have a global criterion that requires that they meet, then it is more efficient to eliminate all candidate rendezvous states where an obstacle is in the state of either actor for any scenario. On the other hand, if Actor A may meet with Actor B OR Actor C, then the strategy that requires non-obstacles in all scenarios before evaluating the criteria, would miss the rendezvous states where Actor B could rendezvous and C could not (and vice-versa). By identifying in advance the non-obstacle scenario patterns required, then this could further reduce the number of global criterion evaluations necessary.

c) Efficiency in Parallelism and Order of Operation

The Boxes 101, 102 and 103 of Figure 1 can be processed in parallel for each scenario since the information contained in each is independent. Further, the operations contained in boxes 101 and 102 can be reversed or performed in parallel.

d) Differential Budding

Differential budding should be used to update the configuration spaces when there are any changes in the environment.

e) Multiple Constraints for the same Machine

Although the simple example used several machines, it is also possible to compute the solution for a single machine that has different types of constraints. For example, a car travelling to a fixed destination may wish to stop before the fuel_level is 1/4 and at least 1 hour into the trip before continuing. The method described above integrates these needs. The locations to stop for fuel could then be found within the rendezvous region.

f) Rendezvous of People.

While most of the examples are for computing the rendezvous locations for machines, it is also desirable to be able to compute the rendezvous states (including location, time, etc.) for people. Each person may have a different ability to move based on terrain, and each person's physical capabilities (running speed, jumping distance, etc.). Based on the rendezvous states found, the people could be directed to follow their own specific paths.

g) Non-physical rendezvous states.

Most of the examples describe a physical meeting location that must be in common for a successful rendezvous. However a rendezvous may also have different simultaneous conditions. For example, a phone conversation requires that the time be simultaneous. If one assumes sparse phone distribution, then a plan must also incorporate information on locations of the possible phones. In this example, a variable at each configuration state identifying if there is a phone at that state could be used in a boolean expression representing the global constraint.

h) Early Stopping Criterion.

For each scenario, there is a configuration space for which wave propagation must take place. Wave propagation in prior patent applications could be stopped once the waves passed the starting state, because further computation would be fruitless. By stopping the wave propagation as early as possible, time can be saved. Similarly, if it were known that after a certain point in the wave propagation for rendezvous that the result of the calculation of the global criterion would always result in FALSE, then continuing wave propagation would also be fruitless, and therefore can be stopped. For example, suppose that the global criterion contained a required subexpression (ActorA_cost < 50). In this example, cost wave propagation could be stopped once the value at the top of the heap (also happening to be the edge of the cost wave) reached 50. In general, subexpressions pertaining to only one actor-scenario can be used to stop the cost wave propagation early.

i) Relative Rendezvous states

In previously described scenarios, the task space was measured from a fixed frame of reference. Similar to the related application on controlling high speed vehicles, a frame of reference may be moving relative to the actors. Problems in docking moving vehicles may be addressed in this way. The method to find acceptable rendezvous states would be performed as previously described, with the only change being that the shared task space is determined based on a moving frame of reference. The candidate rendezvous states found will be relative to the moving frame of reference.

Apparatus Variations

The method described above can be used with many different apparatus configurations. As shown in Fig. 7, what are required are an input device, a processing unit, and an output device. Input device 10 can be a keyboard, a mouse or light pen for locating positions on a map, a spoken-word recognition system, a radar output showing present position of actors and/or obstacles, or a computer system. The central processing unit 12 can be a dedicated calculating and logic unit, a "workstation" or microprocessor, or a more powerful computing machine. Memory 14 is optional, and might include 3-D map or chart data, or a storage device for actor (people or machines) capabilities and limitations. For output, a visual screen display 16 may provide information for a human to use in planning decisions, or may show the planned optimum routes to be taken by robots whose motions are controlled via a controller 18. Alternatively, rendezvous location lists can be printed, or the data can be provided to a computer for further use.

**Claims**

1. A method of selecting paths to at least one rendezvous state (1101), the paths leading from respective sources to the at least one rendezvous state, the method comprising:

   defining (101) a first scenario for travel to achieve a rendezvous condition, the first scenario specifying the location of a first one of the sources and a cost metric,
   defining (101) a second scenario for travel to achieve said rendezvous condition, the second scenario specifying the location of a second one of the sources and a cost metric,
   forming (102) respective configuration spaces based on said scenarios, said respective spaces having at least one task state in common,
   propagating (103) cost waves from the respective source for each configuration space, to determine costs for each configuration state indicating the cost of travel through a said task state in common,
   determining a Boolean expression defining a global criterion, encompassing the ways the rendezvous condition can be achieved,
   for each said task state in common, evaluating (104) costs of corresponding configuration states according to said Boolean expression to identify candidate rendezvous states, and
   providing (105) identification of said candidate rendezvous states to a selecting means for selecting the rendezvous state on the basis of a selection criterion.

2. A method as claimed in Claim 1, wherein the respective source for one of said configuration spaces is a starting state, and the respective source for another of said configuration spaces is a goal state.

3. A method as claimed in Claim 1 or 2, wherein said first scenario is defined for a first actor, said second scenario is defined for a different actor, and said rendezvous condition is simultaneous presence of said first and different actors at a same task state.

4. A method as claimed in Claim 3, wherein said providing step includes displaying a pictorial presentation of said locations, and identifying said candidate rendezvous states by a distinctive presentation.

5. A method as claimed in Claim 3 or 4, including the step of defining a third scenario for travel from said rendezvous condition to a goal, wherein the respective source for one of said configuration spaces is a starting state for said first actor, and the respective source for another of said configuration spaces is said goal.

6. An apparatus (Fig. 7) for selecting paths to at least one rendezvous state (1101), the paths leading from respective sources to the at least one rendezvous state, the apparatus comprising:

means (10) for defining (101) a first scenario for travel to achieve a rendezvous condition, the first scenario specifying the location of a first one of the sources and a cost metric, and a second scenario for travel to achieve said rendezvous condition, the second scenario specifying the location of a second one of the sources and a cost metric,

means (12) for forming (102) respective configuration spaces based on said scenarios, said respective spaces having at least one task state in common,

means (12) for propagating (103) cost waves from the respective source for each configuration space, to determine costs for each configuration state indicating the cost of travel through a said task state in common,

means (10) for determining a Boolean expression defining a global criterion, encompassing the ways the rendezvous condition can be achieved,

means (12) for evaluating, for each said task state in common, said Boolean expression to identify candidate rendezvous states, and

output means (16) for providing (105) identification of said candidate rendezvous states to a selecting means for selecting the rendezvous state on the basis of a selection criterion.

7. An apparatus as claimed in Claim 6, wherein the respective source for one of said configuration spaces is a starting state, and the respective source for another of said configuration spaces is a goal state.

8. An apparatus as claimed in Claim 6 or 7, wherein said first scenario is defined for a first actor, said second scenario is defined for a different actor, and said rendezvous condition is simultaneous presence of said first and different actors at a same configuration state.

9. An apparatus as claimed in Claim 6, 7 or 8, wherein said providing step includes displaying a pictorial presentation of said locations, and identifying said rendezvous states by a distinctive presentation.

10. An apparatus as claimed in Claim 8, including the step of defining a third scenario for travel from said rendezvous condition to a goal, wherein the respective source for one of said configuration spaces is a starting state for said first actor, and the respective source for another of said configuration spaces is said goal.

**Patentansprüche**

1. Verfahren zum Selektieren von Strecken zu wenigstens einem Rendezvous-Zustand (1101), wobei diese Strecken von den betreffenden Quellen zu dem wenigstens einen Rendezvous-Zustand führen, wobei dieses Verfahren die nachfolgenden Verfahrensschritte umfasst:

   - das Definieren (101) eines ersten Szenarios zum Fahren zum Erzielen einer Rendezvous-Bedingung, wobei das erste Szenario die Stelle einer ersten Quelle und ein Kostenmaß spezifiziert,
   - das Definieren (101) eines zweiten Szenarios zum Fahren zu Erzielen der genannten Rendezvous-Bedingung, wobei das zweite Szenario die Stelle einer zweiten Quelle und ein Kostenmaß spezifiziert,
   - das Bilden (102) betreffender Konfigurationsräume auf Basis der genannten Szenarios, wobei die genannten betreffenden Räume wenigstens einen Aufgabenzustand gemeinsam haben,
   - das Propagieren (103) von Kostenwellen von der betreffenden Quelle für jeden Konfigurationsraum, zum bestimmen von Kosten für jeden Konfigurationszustand, der die Kosten der Fahrt durch einen genannten gemeinsamen Aufgabenzustand angibt,
   - das Bestimmen eines booleschen Ausdrucks, der ein umfassendes Kriterium definiert, die verschiedenen Wege umfassend, wie der Rendezvous-Zustand erreicht werden kann,
   - das für jeden genannten gemeinsamen Aufgabenzustand Bewerten (104) von Kosten entsprechender Konfigurationszustände entsprechend dem booleschen Ausdruck zum Identifizieren der Rendezvous-Zustände, und
   - das Liefern (105) einer Identifikation der genannten Kandidat-Rendezvous-Zustände zu einem Selektionsmittel zum Selektieren des Rendezvous-Zustandes auf Basis eines selektiven Kriteriums.

2. Verfahren nach Anspruch 1, wobei die betreffende Quelle für einen der genannten Konfigurationsräume ein Startzustand ist, und die betreffende Quelle für einen anderen Raum der genannten Konfigurationsräume ein Ziel-Zustand ist.

3. Verfahren nach Anspruch 1 oder 2, wobei das genannte erste Szenario für einen ersten Akteur definiert ist, wobei das genannte zweite Szenario für einen anderen Akteur definiert ist und wobei die genannte Rendezvous-Bedingung gleichzeitig anwesend ist für den ersten und den anderen Akteur in demselben Aufgabenzustand.

4. Verfahren nach Anspruch 3, wobei der genannte Lieferungsschritt das Wiedergeben einer bildlichen Darstellung der genannten Stellen umfasst und das Identifizieren der genannten Kandidat-Rendezvous-Zustände durch eine bestimmte andere Darstellung.

5. Verfahren nach Anspruch 3 oder 4, mit dem Verfahrensschritt der Definition eines dritten Szenarios für eine Fahrt von der genannten Rendezvous-Bedingung zu einem Ziel, wobei die betreffende Quelle für einen der genannten Konfigurationsräume ein Start-Zustand für den genannten ersten Akteur ist und die betreffende Quelle für einen anderen Raum der genannten Konfigurationsräume das genannte Ziel ist.

6. Gerät (Fig. 7) zum Selektieren von Strecken zu wenigstens einem Rendezvous-Zustand (1101), wobei die Strecken von den genannten Quellen zu dem wenigstens einen Rendezvous-Zustand führen, wobei das Gerät die nachfolgenden Elemente umfasst:

   - Mittel (10) zum Definieren (101) eines ersten Szenarios zum Erzielen einer Rendezvous-Bedingung, wobei das erste Szenario die Stelle einer ersten Quelle und ein Kostenmaß spezifiziert, und eines zweiten Szenarios zum Fahren zu Erzielen der genannten Rendezvous-Bedingung, wobei das zweite Szenario die Stelle einer zweiten Quelle und ein Kostenmaß spezifiziert,
   - Mittel (12) zum Bilden (102) betreffender Konfigurationsräume auf Basis der genannten Szenarios, wobei die genannten betreffenden Räume wenigstens einen Aufgabenzustand gemeinsam haben,
   - Mittel (12) zum Propagieren (103) von Kostenwellen von der betreffenden Quelle für jeden Konfigurationsraum, zum bestimmen von Kosten für jeden Konfigurationszustand, der die Kosten der Fahrt durch einen genannten gemeinsamen Aufgabenzustand angibt,
   - Mittel (10) zum Bestimmen eines booleschen Ausdrucks, der ein umfassendes Kriterium definiert, die verschiedenen Wege umfassend, wie der Rendezvous-Zustand erreicht werden kann,
   - Mittel (12) um für jeden genannten gemeinsamen Aufgabenzustand den genannten booleschen Ausdruck zum Identifizieren von Kandidat-Rendezvous-Zuständen, und
   - Ausgangsmittel (16) zum Liefern (105) einer Identifikation der genannten Kandidat-Rendezvous-Zustände zu einem Selektionsmittel zum Selektieren des Rendezvous-Zustandes auf Basis eines selektiven Kriteriums.

7. Gerät nach Anspruch 6, wobei die betreffende Quelle für einen der genannten Konfigurationsräume ein Start-Zustand ist und die betreffende Quelle für einen anderen Raum der genannten Konfigurationsräume ein Ziel-Zustand ist.

8. Gerät nach Anspruch 6 oder 7, wobei das genannte erste Szenario für einen ersten Akteur definiert ist, wobei das genannte zweite Szenario für einen anderen Akteur definiert ist, und wobei die genannte Rendezvous-Bedingung für den genannten ersten und zweiten Akteur in demselben Konfigurationszustand gleichzeitig vorhanden ist.

9. Gerät nach Anspruch 6, 7 oder 8, wobei der genannte Lieferungsschritt die Wiedergabe einer bildlichen Darstellung der genannten Stellen, sowie die Identifikation der genannten Rendezvous-Zustände durch eine andere Darstellung umfasst.

10. Gerät nach Anspruch 8, mit dem Schritt der Definition eines dritten Szenarios für die Fahrt von der genannten Rendezvous-Bedingung zu einem Ziel, wobei die betreffende Quelle für einen der genannten Konfigurationsräume ein Start-Zustand für den genannten ersten Akteur ist und die betreffende Quelle für einen anderen Raum der genannten Konfigurationsräume das genannte Ziel ist.

**Revendications**

1. Procédé de sélection de chemins menant à au moins à un état de rendezvous (1101), les chemins allant des sources respectives vers ledit au moins un état de rendez-vous, le procédé comprenant:

   - la définition (101) d'un premier scénario de voyage pour réaliser une condition de rendezvous, le premier scénario spécifiant l'endroit d'une première des sources et une métrique de coût;
   - la définition (101) d'un deuxième scénario de voyage pour réaliser ladite condition de rendez-vous, le deuxième scénario spécifiant l'endroit d'une deuxième des sources et une métrique de coût;
   - la formation (102) d'espaces de configuration respectifs sur la base desdits scénarios, lesdits espaces respectifs ayant au moins un état de tâche en commun;

- la propagation (103) d'ondes de coût à partir de la source respective pour chaque espace de configuration, afin de déterminer les coûts pour chaque état de configuration indiquant le coût de voyage par un état de tâche en commun;
- la détermination d'une expression booléenne définissant un critère global, englobant les façons dont la condition de rendez-vous peut être réalisée;
- pour chaque état de tâche en commun, l'évaluation (104) des coûts des états de configuration correspondants suivant ladite expression booléenne pour identifier les états de rendez-vous candidats, et
- la fourniture (105) de l'identification desdits états de rendez-vous candidats à un moyen de sélection pour sélectionner l'état de rendez-vous sur la base d'un critère global.

**2.** Procédé suivant la revendication 1, dans lequel la source respective d'un desdits espaces de configuration est un état de départ, et la source respective d'un autre desdits espaces de configuration est un état d'objectif.

**3.** Procédé suivant la revendication 1 ou 2, dans lequel ledit premier scénario est défini pour un premier acteur, ledit deuxième scénario est défini pour un acteur différent, et ladite condition de rendez-vous est la présence simultanée dudit premier acteur et de l'acteur différent à un même état de tâche.

**4.** Procédé suivant la revendication 3, dans lequel ladite étape de fourniture comprend l'affichage d'une présentation graphique desdits endroits, et l'identification desdits états de rendez-vous candidats par une présentation distinctive.

**5.** Procédé suivant la revendication 3 ou 4, comprenant l'étape de définition d'un troisième scénario de voyage, allant de ladite condition de rendez-vous jusqu'à un objectif, dans lequel la source respective pour un desdits espaces de configuration est un état de départ pour ledit premier acteur, et la source respective pour un autre desdits espaces de configuration est ledit objectif.

**6.** Appareil (Fig. 7) pour sélectionner des chemins menant vers le au moins un état de rendez-vous (1101), les chemins allant des sources respectives vers ledit au moins un état de rendez-vous, l'appareil comprenant :

- un moyen (10) pour définir (101) un premier scénario de voyage pour réaliser une condition de rendez-vous, le premier scénario spécifiant l'endroit d'une première des sources et une métrique de coût, et un deuxième scénario de voyage pour réaliser ladite condition de rendez-vous, le deuxième scénario spécifiant l'endroit d'une deuxième des sources et une métrique de coût;
- un moyen (12) pour former (102) les espaces de configuration respectifs sur la base desdits scénarios, lesdits espaces respectifs ayant au moins un état de tâche en commun;
- un moyen (12) pour propager (103) des ondes de coût à partir de la source respective pour chaque espace de configuration, pour déterminer les coûts pour chaque état de configuration indiquant le coût de voyage par un état de tâche en commun;
- un moyen (10) pour déterminer une expression booléenne définissant un critère global, englobant les façons dont la condition de rendez-vous peut être réalisée;
- un moyen (12) pour évaluer, pour chaque dit état de tâche en commun, ladite expression booléenne pour identifier les états de rendez-vous candidats, et
- un moyen de sortie (16) pour fournir (105) l'identification desdits états de rendez-vous candidats à un moyen de sélection pour sélectionner l'état de rendez-vous sur la base d'un critère de sélection.

**7.** Appareil suivant la revendication 6, dans lequel la source respective pour un desdits espaces de configuration est un état de départ, et la source respective d'un autre desdits espaces de configuration est un état d'objectif.

**8.** Appareil suivant la revendication 6 ou 7, dans lequel ledit premier scénario est défini pour un premier acteur, ledit deuxième scénario est défini pour un acteur différent, et ladite condition de rendez-vous est une présence simultanée dudit premier acteur et de l'acteur différent à un même état de configuration.

**9.** Appareil suivant la revendication 6, 7 ou 8, dans lequel ladite étape de fourniture comprend l'affichage d'une présentation graphique desdits endroits, et l'identification desdits états de rendez-vous par une présentation distinctive.

**10.** Appareil suivant la revendication 8, comprenant l'étape de définition d'un troisième scénario de voyage allant de ladite condition de rendez-vous à un objectif dans lequel la source respective pour un desdits espaces de configuration est un état de départ pour ledit premier acteur, et la source respective d'un autre desdits espaces de configuration est ledit objectif.

FIG.1

FIG.2

EP 0 609 928 B1

FIG.3

FIG.4

16

FIG.5

FIG.6

FIG.7